(19) **Europäisches Patentamt European Patent Office Office européen des brevets**

(11) **EP 1 067 643 B1**

(12) **FASCICULE DE BREVET EUROPEEN**

(45) Date de publication et mention de la délivrance du brevet:
**30.01.2008 Bulletin 2008/05**

(51) Int Cl.:
*H01S 5/06* (2006.01)     *H01S 5/062* (2006.01)
*G02F 1/015* (2006.01)

(21) Numéro de dépôt: **00401900.6**

(22) Date de dépôt: **03.07.2000**

(54) **Dispositif optique à semiconducteur, à cavité résonante accordable en longueur d'onde, application à la modulation d'une intensite lumineuse**

Optische Halbleitervorrichtung mit einem wellenlängenabstimmbarem Resonanzhohlraum, und Anwendung in Lichtintensitätsmodulation

Optical semiconductor device with a wavelength tunable resonant cavity, and usage in light intensity modulation

(84) Etats contractants désignés:
**DE GB**

(30) Priorité: **07.07.1999 FR 9908783**

(43) Date de publication de la demande:
**10.01.2001 Bulletin 2001/02**

(73) Titulaire: **Commissariat à l'Energie Atomique 75015 Paris (FR)**

(72) Inventeurs:
• **Ortiz, Valentin**
  **75013 Paris (FR)**
• **Pelekanos, Nikolaos**
  **38000 Grenoble (FR)**

(74) Mandataire: **Viering, Jentschura & Partner et al Postfach 22 14 43 80504 München (DE)**

(56) Documents cités:
**EP-A- 0 681 200          US-A- 5 425 042**

• **PATENT ABSTRACTS OF JAPAN vol. 012, no. 291 (E-644), 9 août 1988 (1988-08-09) & JP 63 066983 A (KISO KAISEKI KENKYUSHO:KK), 25 mars 1988 (1988-03-25)**
• **ORTIZ V ET AL: "Tunable semiconductor laser device based on piezoelectric heterostructures" TECHNICAL DIGEST. SUMMARIES OF PAPERS PRESENTED AT THE CONFERENCE ON LASERS AND ELECTRO-OPTICS. POSTCONFERENCE EDITION. CLEO '99. CONFERENCE ON LASERS AND ELECTRO-OPTICS (IEEE CAT. NO. 99CH37013), TECHNICAL DIGEST. SUMMARIES OF PAPERS PRESENTED AT THE, 23 - 28 mai 1999, pages 154-155, XP000901212 1999, Washington, DC, USA, Opt. Soc. America, USA ISBN: 1-55752-595-1**

## Description

## DOMAINE TECHNIQUE

La présente invention concerne un dispositif optique à semiconducteur, à cavité résonante accordable en longueur d'onde.

Ce dispositif est susceptible d'être fabriqué aussi bien sous la forme d'une source de lumière cohérente, par exemple un laser à émission verticale, également appelé VCSEL dans la suite, ou un laser à émission par la tranche (« edge emission »), que sous la forme d'une source de lumière incohérente, par exemple une diode électroluminescente (« light emitting diode »), également appelée LED dans la suite et ayant une émission verticale ou une émission par la tranche.

Le dispositif objet de l'invention est également susceptible d'être fabriqué sous la forme d'un modulateur optique fonctionnant en réflexion ou en transmission.

L'invention trouve des applications dans divers domaines tels que par exemple les télécommunications optiques, les réseaux tout-optiques (« all optical networks »), l'affichage d'informations et la spectroscopie.

## ÉTAT DE LA TECHNIQUE ANTÉRIEURE

On rappelle que dans une diode à émission verticale les miroirs qui délimitent la cavité résonante de la diode sont formés perpendiculairement à l'axe de croissance des couches enserrant la zone active et l'espaceur (« spacer ») qui se trouvent dans la cavité. Cet espaceur est lui-même compris entre la zone active et les miroirs de la cavité.

Cette cavité peut avoir une longueur de l'ordre de 1 $\mu$m et s'appelle alors une « micro-cavité ». Dans une telle micro-cavité un seul mode optique est en général sélectionné à cause de la faible épaisseur de la micro-cavité, alors que dans une cavité résonante plus épaisse, on peut avoir plusieurs modes optiques.

Les diodes à émission verticale, qu'elles soient du genre VCSEL ou LED, offrent d'énormes potentialités pour le marché des télécommunications optiques grâce à :

■ leur simplicité de fabrication qui permet de former des matrices comportant un grand nombre d'émetteurs de lumière,
■ la qualité du mode électromagnétique de leur émission lumineuse, et
■ leur facilité d'intégration dans des circuits optoélectroniques.

On connaît déjà des diodes lasers à émission verticale qui sont accordables par variation de température, par le document [1] qui, comme les autres documents cités par la suite, est mentionné à la fin de la présente description. De telles diodes ont un temps de réponse très long, de l'ordre de 1 seconde, et une faible plage d'accordabilité.

On connaît également par le document [2] une diode à émission verticale, accordable au moyen d'une membrane déformable, qui est commandée électriquement et constitue le miroir de sortie de la cavité résonante de la diode. Cette dernière est susceptible d'avoir une accordabilité de plusieurs dizaines de nanomètres. Cependant, elle est difficile à fabriquer et, de ce fait, plutôt coûteuse. En outre, l'utilisation d'une membrane déformable conduit à un temps de réponse assez long, de l'ordre de 1 $\mu$s.

Dans le domaine des diodes à émission par la tranche, on connaît, par le document [3], des diodes lasers accordables par variation de température. De telles diodes ont un temps de réponse très long, de l'ordre de 1 seconde, et une plage d'accordabilité plutôt limitée.

On connaît aussi, par le document [4], des diodes lasers à émission par la tranche qui sont accordables au moyen d'un réseau (« grating ») de diffraction externe. De telles diodes ont un temps de réponse de l'ordre de 1 milliseconde et sont de plus massives et très coûteuses.

On connaît en outre par le document [5], auquel on se reportera, des diodes lasers accordables, à émission par la tranche, dont la cavité résonante comprend une région active, une région à indice de réfraction variable (déphaseur) et une région formant un réflecteur de Bragg réparti (« distributed Bragg reflector ») ou DBR, régions qui sont intégrées de façon monolithique sur un substrat.

Quand un courant passe à travers la région active on obtient un effet d'émission stimulée avec un spectre de gain sur une plage assez importante. Dans cette plage, un nombre important de modes de cavité est disponible. Néanmoins, comme le DBR possède un seul maximum à une longueur d'onde $\lambda_f$, un seul mode de cavité peut effectivement conduire à un rayonnement laser. Dans cette configuration, l'accordabilité est obtenue en faisant passer un courant dans le DBR, ce qui change l'indice de réfraction dans ce DBR par un effet de plasma et décale donc $\lambda_f$ c'est-à-dire la longueur d'onde d'émission.

Malgré ce décalage, les modes de cavité demeurent quasiment inchangés et l'émission passe donc de manière discontinue d'un mode à l'autre. C'est pour éviter cet effet que l'on utilise la région à indice de réfraction variable qui est commandée par un courant électrique indépendamment du DBR. Ce changement d'indice de réfraction est suffisant pour décaler les modes de cavité qui peuvent alors suivre la variation de $\lambda_f$. Ceci permet d'obtenir une variation continue de la longueur d'onde d'émission.

Le temps de réponse de telles diodes est directement lié aux durées de vie des porteurs de charge dans la région à indice de réfraction variable et dans la région du DBR et vaut environ une nanoseconde.

Cependant ces diodes sont difficiles à fabriquer et donc coûteuses et nécessitent de plus des moyens électroniques complexes pour commander la longueur d'onde du rayonnement laser émis car trois courants électriques sont nécessaires à cet effet (un courant pour chacune des régions mentionnées plus haut).

## EXPOSÉ DE L'INVENTION

La présente invention a pour but de remédier aux inconvénients précédents en proposant un dispositif optique à semiconducteur, à cavité résonante accordable en longueur d'onde, qui est plus simple à fabriquer et donc moins coûteux que les dispositifs connus par les documents [2] et [5], tout en étant rapide, ce dispositif étant susceptible d'avoir un temps de réponse, c'est-à-dire un temps de commutation de longueur d'onde, de l'ordre de 1 nanoseconde voire moins.

De façon précise, la présente invention a pour objet un dispositif optique à semiconducteur, à cavité résonante accordable en longueur d'onde, ce dispositif comprenant une cavité résonante et deux miroirs qui délimitent cette cavité, ce dispositif étant caractérisé en ce qu'il comprend en outre :

■ au moins un super-réseau (« super-lattice »), qui est placé dans la cavité et formé à partir de couches semiconductrices piézoélectriques, et

■ des premiers moyens d'injection de porteurs de charge dans le super-réseau,

de manière à pouvoir modifier les propriétés optiques de ce super-réseau lorsque les porteurs de charge sont injectés dans ce dernier et obtenir ainsi un décalage en longueur d'onde des modes de résonance de la cavité.

L'effet « piézoélectrique » est ici pris au sens large et regroupe aussi bien les phénomènes d'apparition d'un champ électrique dans une couche semiconductrice contrainte (« strained ») que les phénomènes de polarisation spontanée dans les couches semiconductrices de type wurzite où un champ électrique est susceptible d'apparaître sans que de telles couches soient contraintes. A ce sujet on se reportera au document [6] .

Le dispositif peut comprendre en outre une zone active placée dans la cavité et destinée à émettre un rayonnement lors de l'injection de porteurs de charge dans cette zone active.

Cette émission de rayonnement peut être aussi bien une émission cohérente (laser) qu'une émission incohérente.

Selon un premier mode de réalisation particulier du dispositif objet de l'invention, les premiers moyens d'injection de porteurs de charge sont en outre prévus pour injecter ces porteurs de charge dans la zone active pour que cette zone active émette le rayonnement.

Selon un deuxième mode de réalisation particulier, le dispositif comprend en outre des deuxièmes moyens d'injection de porteurs de charge prévus pour injecter ces porteurs de charge dans la zone active pour que cette zone active émette le rayonnement.

Ces porteurs de charge sont alors indépendants de ceux que l'on injecte dans le super-réseau qui est formé à partir des couches semiconductrices piézoélectriques et appelé SR-P par la suite.

Dans un premier exemple, le dispositif objet de l'invention est apte à émettre un rayonnement laser, les miroirs étant perpendiculaires à l'axe de croissance des couches semiconductrices que comporte le dispositif, de manière à obtenir une émission verticale du rayonnement laser.

Dans un deuxième exemple, le dispositif objet de l'invention est apte à émettre un rayonnement incohérent, les miroirs étant perpendiculaires à l'axe de croissance des couches semiconductrices que comporte le dispositif, de manière à obtenir une émission verticale du rayonnement incohérent.

Dans un troisième exemple, le dispositif objet de l'invention est apte à émettre un rayonnement laser, les miroirs étant parallèles à l'axe de croissance des couches semiconductrices que comporte le dispositif, de manière à obtenir une émission par la tranche du rayonnement laser.

Dans un quatrième exemple, le dispositif objet de l'invention est apte à émettre un rayonnement incohérent, les miroirs étant parallèles à l'axe de croissance des couches semiconductrices que comporte le dispositif, de manière à obtenir une émission par la tranche du rayonnement incohérent.

Les premier, troisième et quatrième exemples ci-dessus s'appliquent en particulier aux télécommunications optiques tandis que le deuxième exemple s'applique en particulier à l'affichage d'informations et à la spectroscopie (détection de gaz ou de polluants).

Les premiers moyens d'injection de porteurs de charge peuvent être de type électrique.

En variante, ces premiers moyens d'injection peuvent être de type optique.

Les couches semiconductrices piézoélectriques peuvent avoir des structures cristallines de type zincblende.

En variante, ces couches semiconductrices piézoélectriques peuvent avoir des structures cristallines de type wurtzite.

Dans un mode de réalisation particulier du dispositif objet de l'invention, ce dispositif ne comprend pas de couche active dans sa cavité résonante et constitue un modulateur optique fonctionnant en réflexion ou en transmission et apte à moduler une lumière incidente en utilisant la variation des modes de la cavité. L'état passant ou non-passant du modulateur est déterminé par la position de ces modes. Ce modulateur trouve des applications en particulier dans les télécommunications optiques et les réseaux tout-optiques.

La vitesse de modulation d'un dispositif conforme à l'invention peut aller au-delà de 1 GHz pour une accordabilité de l'ordre de quelques nanomètres.

L'invention concerne aussi un dispositif de modulation d'intensité lumineuse comprenant un dispositif optique conforme à l'invention qui comporte une zone active placée dans la cavité résonante de ce dispositif optique, ce dernier étant optiquement couplé à une autre cavité résonante sans zone active mais dans laquelle est placé un super-réseau formé à partir de couches semiconductrices piézoélectriques, cette autre cavité étant apte à résonner à une ou une pluralité de longueurs d'onde accordables.

L'invention concerne en outre un dispositif de modulation d'intensité lumineuse comprenant un dispositif optique conforme à l'invention qui comporte une zone active placée dans la cavité résonante de ce dispositif optique, ce dernier étant optiquement couplé à une autre cavité résonante sans zone active ni super-réseau formé à partir de couches semiconductrices piézoélectriques, cette autre cavité étant apte à résonner à une ou une pluralité de longueurs d'onde fixes.

## BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :

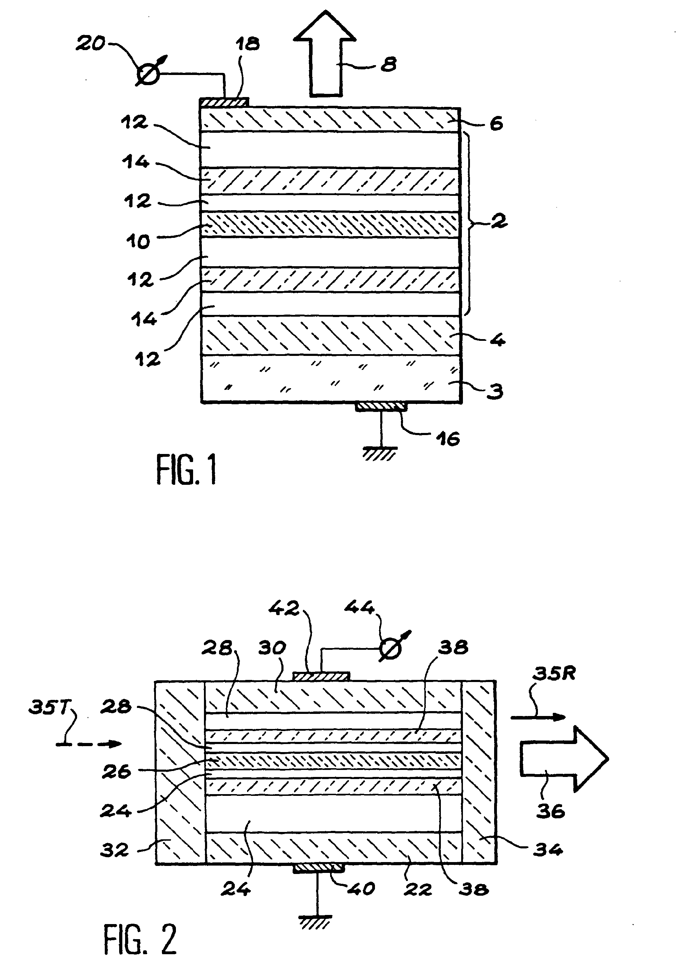

♦ la figure 1 illustre schématiquement un premier mode de réalisation particulier du dispositif objet de l'invention, à émission verticale,

♦ la figure 2 illustre schématiquement un deuxième mode de réalisation particulier, à émission par la tranche,

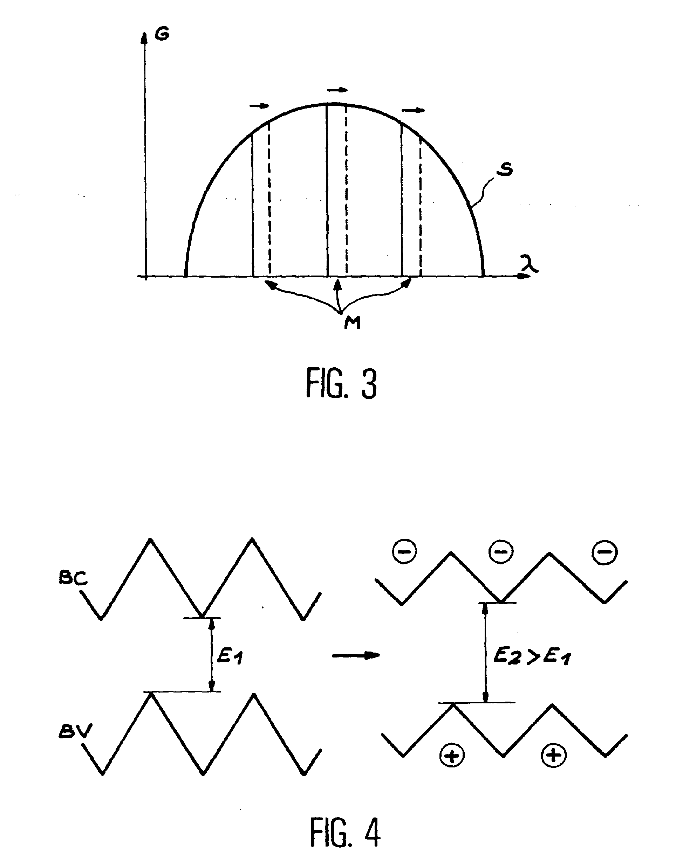

♦ la figure 3 montre un spectre de gain pour une diode laser conforme à l'invention, à émission par la tranche,

♦ la figure 4 montre l'évolution d'un diagramme de bande d'une portion d'un super-réseau piézoélectrique lorsqu'on y injecte des porteurs de charge,

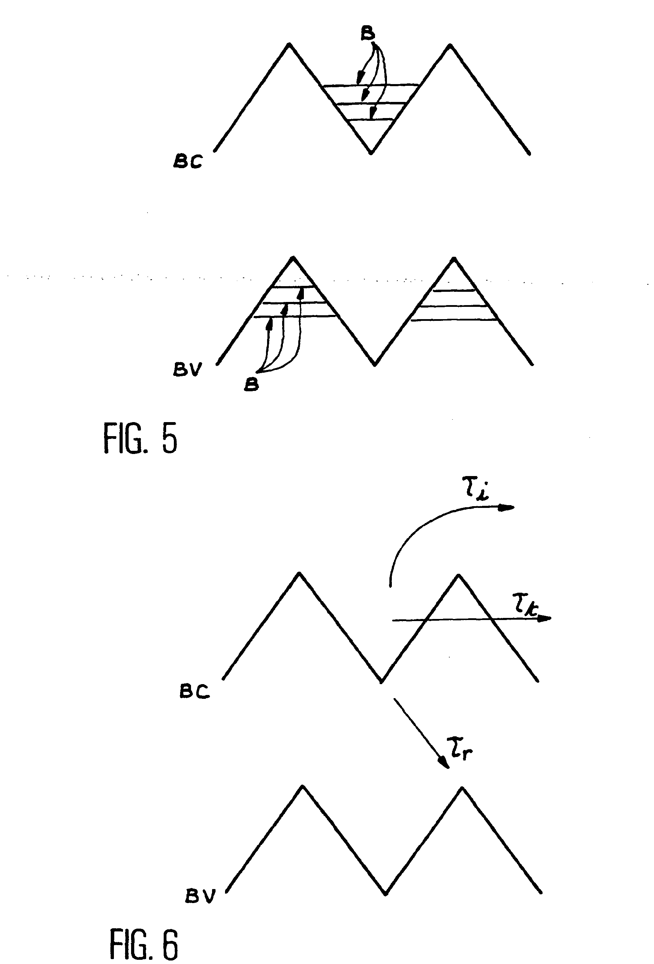

♦ la figure 5 est un diagramme de bande montrant des niveaux quantiques confinés dans un super-réseau piézoélectrique,

♦ la figure 6 est un diagramme de bande d'un super-réseau piézoélectrique sur lequel on a symbolisé différents temps utilisés pour estimer le temps de réponse d'un dispositif conforme à l'invention,

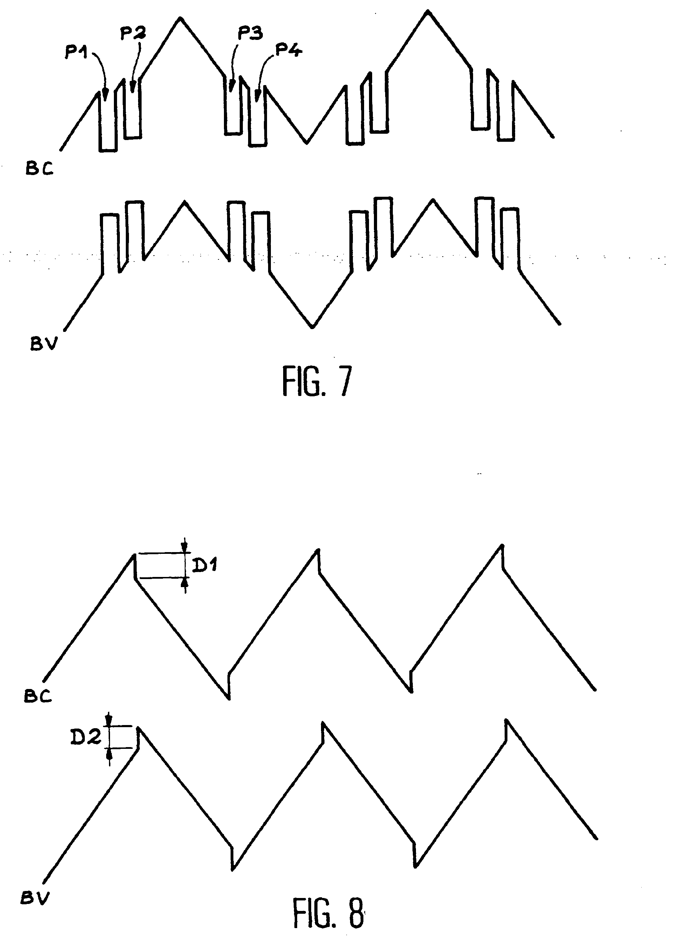

♦ la figure 7 est un diagramme de bande correspondant à deux périodes d'un super-réseau piézoélectrique contenant des puits quantiques (« quantum wells »),

♦ la figure 8 est un diagramme de bande correspondant à trois périodes d'un super-réseau piézoélectrique avec une bande interdite différente pour les deux matériaux du super-réseau,

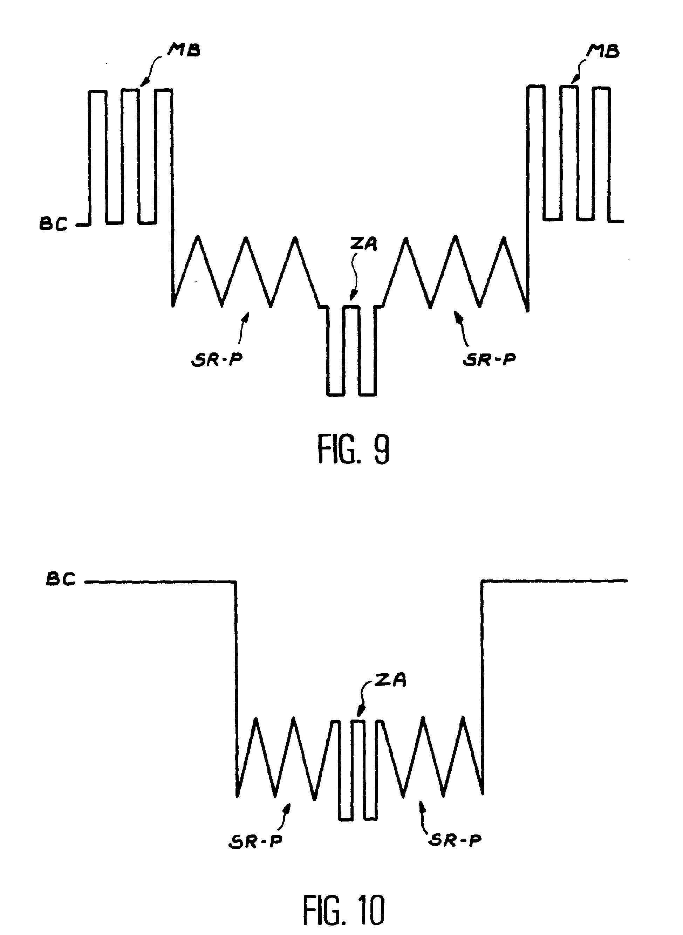

♦ la figure 9 est un diagramme de bande de conduction correspondant à un exemple de diode conforme à l'invention, à émission verticale, contenant une zone active formée de puits quantiques et incluse dans un super-réseau piézoélectrique, et

♦ la figure 10 est un diagramme de bande de conduction correspondant à un exemple de diode conforme à l'invention, à émission par la tranche, contenant une zone active formée de puits quantiques et un super-réseau piézoélectrique inclus dans une structure à confinement d'indice du genre hétérostructure à confinement séparé.

## EXPOSÉ DÉTAILLÉ DE MODES DE RÉALISATION PARTICULIERS

Comparons d'abord l'invention aux dispositif connus par le document [2].

Un dispositif conforme à l'invention, du genre VCSEL ou LED à émission verticale, se distingue des diodes connues par le document [2] par son processus de fabrication beaucoup plus simple et par sa vitesse de commutation beaucoup plus élevée, du fait de son principe de fonctionnement radicalement différent.

De plus, on peut réaliser un tel dispositif conforme à l'invention n'utilisant qu'un seul courant de commande, ce qui simplifie grandement l'intégration de ce dispositif dans des systèmes optoélectroniques.

L'accordabilité d'un tel dispositif vaut environ 10 nm et son temps de réponse vaut environ 1 nanoseconde.

Un dispositif semiconducteur émetteur de lumière conforme à l'invention, à émission verticale, est schématiquement représenté sur la figure 1. Ce dispositif comprend une microcavité résonante 2 formée sur un substrat semiconducteur 3 de type N et délimitée par un miroir inférieur 4 en matériau semiconducteur de type N, en contact avec le substrat, et par un miroir supérieur 6 en matériau semiconducteur de type P à travers lequel est émis le rayonnement 8 engendré dans le dispositif. Bien entendu, d'autres associations de dopages sont envisageables, par exemple en inversant les zones de types N et P.

La microcavité contient une zone active 10 (milieu à gain positif) comprenant un ou une pluralité de puits quantiques (« quantum wells ») et, de part et d'autre de cette zone, un espaceur 12 en matériau semiconducteur.

En outre un ou une pluralité de super-réseaux en matériau semiconducteur piézoélectrique, appelés SR-P dans la suite, sont inclus dans l'espaceur, par exemple entre la zone active 10 et le miroir 4 et/ou entre cette zone 10 et le miroir 6.

La zone active 10 n'est pas forcément au centre de la microcavité mais elle est de préférence placée sur un ventre du champ électromagnétique stationnaire établi dans la microcavité résonante 10. Au lieu de cela, la zone active pourrait être répartie à plusieurs endroits de la microcavité et placée sur plusieurs des ventres du champ électromagnétique.

On voit aussi sur la figure 1 une électrode 16 en contact avec le substrat 3 et mise à la masse et une autre électrode 18 en contact avec le miroir supérieur 6 et reliée à une source de tension négative variable 20. Cela permet de polariser en direct (et de façon variable) la diode que constitue le dispositif de la figure 1 et d'injecter des porteurs de charge dans le ou les SR-P.

Le fonctionnement de ce dispositif, qui est accordable en longueur d'onde, est fondé sur l'utilisation des effets électro-optiques des semiconducteurs, par exemple l'effet Franz Keldysh ou l'effet Stark confiné quantique (« quantum confined Stark effect »). A ce sujet on se reportera au document [7].

Chaque SR-P 14 est conçu de telle sorte que la présence de porteurs de charge dans celui-ci modifie ses propriétés optiques (coefficient d'absorption, mais surtout indice de réfraction). Dans ce cas, lorsqu'on injecte des porteurs dans la microcavité 2 pour obtenir l'émission de lumière, ceux-ci se répartissent en même temps dans la zone active 10 et le SR-P en y induisant une modification de l'indice de réfraction.

Si la résonance de la microcavité se situe dans cette plage de variation d'indice de réfraction, la microcavité en subit l'effet et on obtient un décalage de la longueur d'onde de la résonance.

Comme le SR-P est tel que les porteurs qui y sont injectés peuvent servir aussi à l'émission de lumière dans la zone active 10, l'injection des porteurs peut induire d'une part une émission stimulée et d'autre part une variation continue de la longueur d'onde d'émission. On a donc la possibilité d'utiliser un seul courant de commande.

Mais on peut aussi utiliser un courant de commande pour l'émission de lumière et une injection optique de porteurs pour modifier l'indice optique du ou des SR-P. Inversement, on peut utiliser une injection optique de porteurs pour l'émission de lumière et une commande électrique pour modifier l'indice du ou des SR-P.

Si l'émission de lumière est une émission laser, on obtient un VCSEL accordable en longueur d'onde. S'il s'agit d'une émission spontanée, on obtient une diode électroluminescente (LED) accordable en longueur d'onde.

Comparons ensuite l'invention aux dispositifs connus par le document [5].

Un dispositif semiconducteur émetteur de lumière conforme à l'invention, à émission par la tranche, est schématiquement représenté sur la figure 2. Ce dispositif comprend un empilement semiconducteur comprenant successivement un substrat semiconducteur 22 de type N, une première couche de barrière 24, une couche active 26, une deuxième couche de barrière 28 et une couche semiconductrice 30 de type P.

Des miroirs 32 et 34 sont respectivement formés aux deux extrémités de cet empilement, parallèlement à l'axe de croissance de ce dernier, et délimitent la cavité résonante du dispositif. Le miroir 32 est apte à réfléchir la lumière engendrée dans la couche active tandis que le miroir 34 est partiellement transparent pour laisser passer une partie 36 de cette lumière.

L'empilement comprend en outre au moins un SR-P référencé 38 dans la couche de barrière 24 et/ou dans la couche de barrière 28. Une électrode 40 est formée sur le substrat 22 et mise à la masse et une autre électrode 42 est formée sur la couche 30 et reliée à une source de tension variable négative 44 permettant de polariser en direct (et de façon variable) la diode que constitue le dispositif de la figure 2 et d'injecter des porteurs de charge dans la cavité résonante de ce dispositif.

Ces porteurs de charge sont ainsi injectés dans la couche active 26, ce qui engendre l'émission de lumière, et aussi dans le ou les SR-P. Ces porteurs de charge changent donc l'indice optique du ou des SR-P, ce qui change la position des modes de la cavité résonante.

Ceci est schématiquement illustré par la figure 3 où $\lambda$, M, G et S représentent respectivement la longueur d'onde de la lumière émise, les modes de la cavité, le gain et le spectre de gain. Si le spectre de gain de la partie active est situé dans une zone où la variation de la longueur d'onde des modes de la cavité est significative, alors on peut commander de manière continue la longueur d'onde des modes d'émission et obtenir en même temps l'émission de lumière.

En conclusion, lors de l'injection de porteurs on a d'une part une émission de lumière et d'autre part un décalage des modes d'émission.

Mais on peut aussi utiliser un courant de commande pour l'émission de lumière et une injection optique de porteurs pour modifier l'indice optique du ou des SR-P. Inversement, on peut utiliser une injection optique de porteurs pour l'émission de lumière et une commande électrique pour modifier l'indice du ou des SR-P.

Le temps de réponse du dispositif de la figure 2 vaut environ 1 ns et sa plage d'accordabilité vaut quelques nanomètres.

Ce dispositif accordable de la figure 2, peut être utilisé soit de manière indépendante soit comme élément d'un laser à trois étages intégrés monolithiquement, tel que le laser accordable du document [5]. Ce dispositif peut remplacer les deux premiers étages de ce laser accordable, c'est-à-dire la région active et la zone à variation d'indice de réfraction, dont le rôle, comme on l'a vu, est de décaler la longueur d'onde des modes de cavité.

En général, on peut inclure le SR-P dans l'un quelconque des étages du laser du document [5] de manière à améliorer ses performances.

La présente invention est aussi utilisable pour réaliser des modulateurs de Fabry-Pérot électro-optiques ou tout-optiques. On utilise alors la variation de la résonance non pas pour faire varier la longueur d'onde d'une émission (il n'y a pas de zone active dans ces modulateurs) mais pour moduler un signal optique en réflexion ou en transmission.

Les modulateurs électro-optiques sont d'une grande importance pour les réseaux (« networks ») de télécommunications optiques car la réception de signaux multiplexés nécessite une bonne sélectivité en longueur d'onde. Les modulateurs tout-optiques sont quant à eux utiles pour la réalisation de mémoires optiques ou de circuits tout-optiques.

Un modulateur conforme à l'invention est une alternative au dispositif connu par le document [8]. Ce modulateur est identique au dispositif des figures 1 et 2 mais ne comprend pas de zone active.

De plus, dans le cas d'un fonctionnement en transmission, la lumière incidente que l'on veut moduler (référence 35T sur la figure 2) est envoyée vers le miroir 32 qui doit être partiellement transparent à cette lumière, la référence 36 correspondant alors à la lumière modulée, tandis que dans le cas d'un fonctionnement en réflexion la lumière 35R que l'on veut moduler est envoyée vers le miroir 34 et le miroir 32 peut demeure un simple réflecteur. Ce fonctionnement peut s'appliquer également au dispositif de la figure 1.

L'injection de porteurs dans la cavité du modulateur induit seulement un décalage de la résonance. C'est la variation de la résonance qu'on utilise pour définir l'état « passant » et l'état « non-passant » du modulateur. L'injection de porteurs, qu'elle soit électrique ou optique, induit donc la modulation. Ceci permet notamment d'utiliser un même composant en polarisation directe et en pompage optique.

Le temps de réponse de modulateurs conformes à l'invention peut être abaissé jusqu'à une fraction de nanoseconde.

Certes, on connaît des dispositifs qui permettent de faire varier l'indice optique d'une couche et qui peuvent être utilisés pour faire varier les modes d'une cavité. Mais aucun de ces dispositifs ne permettrait d'envisager l'émission de lumière en même temps que la commande de la longueur d'onde des modes.

On connaît par exemple, par le document [8], une microcavité contenant une couche dont on fait varier l'indice optique par application d'un champ électrique à cette couche. Cependant cela ne permettrait pas de réaliser des diodes émettrices de lumière, à longueur d'onde accordable, conformes à l'invention car ces diodes nécessitent non seulement l'application d'un champ électrique pour faire varier la (ou les) résonance(s) mais aussi l'injection des porteurs de charge pour obtenir l'effet laser. Or ceci n'est pas possible avec la microcavité connue par le document [8] étant donné que l'injection des porteurs de charge écranterait le champ électrique appliqué et empêcherait ainsi l'accordabilité.

On connaît aussi des dispositifs appelés « nipis » mais, dans ces derniers, on ne peut, pour une même densité de puissance injectée, avoir en même temps un effet de variation d'indice optique et un effet d'émission de lumière. Les structures de type « nipi » ne peuvent donc servir à réaliser des émetteurs de lumière à longueur d'onde accordable comme on le verra mieux par la suite. D'ailleurs, leur domaine d'application se limite essentiellement à la modulation de la lumière.

Revenons sur le principe de fonctionnement de l'invention.

Cette invention est fondée sur l'utilisation de l'effet piézo-électrique. Pour les semiconducteurs ayant une structure cristallographique du genre zincblende, les couches piézo-électriques sont des couches contraintes (« strained »), obtenues par croissance épitaxiale sur des substrats dont les indices cristallographiques <n,l,m> sont élevés, avec $n \times l \times m \neq 0$, comme par exemple <111> ou <211>.

On sait par le document [9] qu'une contrainte biaxiale dans le plan de ce type de couche génère un champ électrique le long de l'axe de croissance des couches.

Les champs piézoélectriques dans les semiconducteurs peuvent facilement atteindre des valeurs dépassant 100kV/cm pour des valeurs modérées de désaccord en paramètre de maille (voir le document [10]).

La structure proposée dans la présente invention est fabriquée sur un substrat par exemple semiconducteur et, dans un mode de réalisation préféré, elle est constituée d'une alternance de deux types de couches qui ont la même bande interdite et où règnent des champs électriques de sens opposés, d'origine piézo-électrique. Le super-réseau en matériau semiconducteur piézo-électrique, ou SR-P, ainsi obtenu est inclus dans une cavité résonante.

La figure 4 montre un exemple de ce genre de dispositif. La bande de valence et la bande de conduction sont respectivement notées BV et BC.

Sur la figure 4, $E_1$ représente la différence entre les minima des bandes et $E_2$, qui est supérieur à $E_1$, représente la différence entre les minima des bandes lorsqu'on injecte les porteurs.

Lors de l'injection des porteurs de charge dans la cavité résonante du dispositif, les champs électriques alternés du SR-P séparent les électrons (-) et les trous (+) qui viennent s'accumuler aux interfaces des deux types de couches, les électrons d'une part et les trous de l'autre. Le champ de charge d'espace ainsi formé écrante les champs piézo-électriques présents dans la structure, ce qui change l'absorption des couches du SR-P.

Si les caractéristiques du SR-P sont telles qu'il existe des niveaux quantiques confinés dans le SR-P, alors le changement d'absorption est dû à une variante de l'effet Stark quantique confiné (voir la figure 5 où les lignes B symbolisent les niveaux d'énergie confinés du SR-P), avec la particularité qu'il s'agit plutôt ici de transitions de type II (indirectes dans l'espace).

Au contraire, si les caractéristiques du SR-P sont telles qu'il n'existe pas de niveaux confinés dans le SR-P, le changement d'absorption est plutôt dû à une variante de l'effet Franz-Keldysh.

Dans les deux cas, la variation du coefficient d'absorption se traduit par une variation de l'indice de réfraction de la cavité.

Si la cavité est une microcavité, on n'a en général qu'un seul mode de résonance. Pour pouvoir contrôler la longueur d'onde de ce mode, il faut qu'il soit dans une plage où la variation d'indice provoquée par l'injection de porteurs est importante.

Dans le cas où la cavité n'est pas une microcavité et qu'on a beaucoup de modes, tous les modes présents dans la plage de variation d'indice optique sont décalés.

La variation de la position d'une résonance est liée à la variation d'indice par la relation suivante, en supposant la cavité résonante parfaite :

$$\frac{\Delta n}{n} = \frac{\Delta \lambda}{\lambda}$$

où n est l'indice de réfraction moyen de la cavité et $\lambda$ la longueur d'onde de la résonance.

Dans une cavité réelle, il faut tenir compte de l'éventuelle pénétration du champ électromagnétique dans les miroirs qui délimitent la cavité et de la variation de l'indice optique avec la longueur d'onde. Ainsi, dans le cas d'une microcavité, la variation de la longueur d'onde peut valoir environ 60% de la valeur idéale (voir le document [8]). Pour une cavité formée avec des faces clivées, elle en vaut plutôt 90%.

Ainsi, une variation de 1% de l'indice optique peut permettre d'obtenir, pour une microcavité à 1,5 $\mu$m, une accordabilité de 8 nm sur un mode. On rappelle que la variation $\Delta n$ de l'indice optique est reliée à la variation $\Delta \alpha$ de l'absorption par la relation de Kramers-Kronig.

L'étude de l'effet Franz-Keldysh dans des matériaux massifs et de l'effet Stark quantique confiné (voir les documents [11], [12] et [13]) dans des multipuits quantiques montre la possibilité, à température ambiante, d'une variation d'indice optique pouvant aller jusqu'à 1% pour des champs de 100kV/cm.

En utilisant un modèle simple de condensateur plan, on peut évaluer la densité de charges qui est nécessaire pour obtenir des champs de l'ordre de 100kV/cm à l'intérieur du SR-P à quelques $6 \times 10^{11}$ cm$^{-2}$. Ceci est aisément réalisable avec les densités d'excitation dont on dispose.

L'injection, de porteurs peut donc permettre de commander la longueur d'onde de la résonance de la microcavité de manière continue.

Par ailleurs, il est clair que pour les deux applications de l'invention à l'émission stimulée, on ne peut placer la longueur d'onde d'émission, et donc la longueur d'onde de la résonance, sur la zone de variation d'indice optique maximum, qui correspond en général à une zone de forte absorption : il faut placer la résonance de la cavité en « queue » d'absorption. Ceci diminue la plage de la variation de l'indice optique et donc la plage d'accordabilité.

Pour avoir un émetteur de lumière accordable, il faut que l'effet laser et l'effet d'accordabilité fonctionnent pour les mêmes densités de porteurs injectés. D'une part, l'effet laser dans les semiconducteurs est obtenu pour des densités de courant de l'ordre de 1 kA/cm$^2$. D'autre part, la densité de porteurs nécessaire au chargement du SR-P est de l'ordre de $6 \times 10^{11}$ charges par cm$^2$. Pour remplir ces deux conditions, la durée de vie des porteurs dans le SR-P doit être de l'ordre d'une centaine de picosecondes, durée de vie qui n'est pas accessible par les structures de type « *nipi* », mais qui peut être obtenue avec des SR-P.

Le temps de « montée » du dispositif (c'est-à-dire le temps nécessaire à « charger » la structure) est égal au temps de désexcitation des porteurs jusqu'au bas des bandes. Ce temps est de l'ordre d'une dizaine de picosecondes car les processus de désexcitation sont essentiellement non radiatifs et gouvernés par les interactions avec les phonons. On peut donc dire que le temps de montée est quasiment nul.

En ce qui concerne le temps de descente (c'est-à-dire le temps que met la structure à se décharger), il est de l'ordre de la durée de vie des porteurs dans chaque « creux » du SR-P. Cette durée de vie $\tau$ est donnée par la formule suivante :

$$\frac{1}{\tau} = \frac{1}{\tau_r} + \frac{1}{\tau_i} + \frac{1}{\tau_t}$$

où $\tau_r$ est la durée de vie radiative des porteurs dans les « creux » du SR-P, $\tau_t$ est le temps d'échappement par effet tunnel à travers les barrières entourant les « creux », $\tau_i$ est le temps d'échappement thermoïonique des porteurs au-dessus des barrières (voir la figure 6) .

La durée de vie des porteurs dépend donc énormément de la structure : suivant ses caractéristiques, on peut par exemple faire varier $\tau$ entre une centaine de picosecondes et 1 $\mu$s. On peut envisager ce dernier cas si les électrons et les trous sont spatialement très séparés par des barrières élevées, ce qui est notamment le cas si la période du super-réseau est grande.

Selon une autre variante de l'invention, un ou plusieurs puits quantiques tels que P1, P2, P3, P4 (figure 7) peuvent être inclus dans le SR-P. Dans ce cas l'injection de porteurs dans la cavité change l'absorption des puits, principalement grâce à l'effet Stark quantique confiné, ce qui provoque un changement de l'indice de réfraction et donc un décalage en longueur d'onde des modes de la cavité.

Dans un cas plus général que celui de la figure 7, ces puits quantiques peuvent aussi disposer d'un champ électrique.

D'autres variantes peuvent être envisagées : (a) on peut par exemple placer des puits de collection de porteurs dans le SR-P ou (b) la bande interdite peut être différente dans les deux matériaux constitutifs du SR-P ou (c) les deux matériaux peuvent avoir la même bande interdite mais un décalage de bande de valence (« valence band offset ») non-nul (voir la figure 8 où les références D1 et D2 symbolisent respectivement les décalages de la bande de conduction et de la bande de valence).

L'essentiel est que, lors de l'injection de porteurs, les paires électron-trou soient localement séparées pour permettre de créer des champs de charge d'espace dans le SR-P, de manière à modifier son absorption.

Dans une autre variante, si la différence de bande interdite entre les deux matériaux est importante et la période du SR-P courte, on est ramené au cas où l'on a des puits piézoélectriques, c'est-à-dire des puits où règne un champ d'origine piézoélectrique. Lorsqu'on injecte des porteurs, ceux-ci, en s'accumulant dans les puits, écrantent le champ piézoélectrique, ce qui change l'absorption et donc l'indice de réfraction de la couche.

On considère maintenant des exemples de l'invention.

Le premier exemple est schématiquement illustré par la figure 9 et concerne une diode à émission verticale. Entre les deux miroirs de Bragg MB qui délimitent la microcavité résonante de la diode, on inclut le SR-P et une zone active ZA constituée d'un ou de plusieurs puits quantiques, de façon à obtenir une émission de lumière lors de l'injection de porteurs. Ces puits quantiques forment l'état fondamental de toute la structure et ne sont pas nécessairement placés au centre de la microcavité mais dans un ou éventuellement plusieurs « ventres » du champ électromagnétique.

De plus, les puits quantiques sont tels que le spectre de gain de la zone active contienne la longueur d'onde du mode de la microcavité, qui a son tour se trouve dans une plage où l'on a une variation d'indice lors de l'injection de porteurs.

On peut donc obtenir une émission de lumière tout en faisant varier le mode de résonance de la microcavité. S'il s'agit d'une émission laser, on a un VCSEL accordable en longueur d'onde et, s'il s'agit simplement d'une émission spontanée, on a une diode électro-luminescente (LED) accordable.

Les puits quantiques de la zone active peuvent éventuellement être entourés de barrières fines et élevées pour augmenter le confinement et empêcher la fuite des porteurs qui induisent l'émission laser.

Le deuxième exemple est schématiquement illustré par la figure 10 et concerne une diode à émission par la tranche. On inclut la zone active ZA dans une structure de type SCH c'est-à-dire une hétérostructure à confinement séparé (« separate confinement heterostructure ») où les barrières entourant la zone active contiennent un SR-P. Les puits quantiques de la zone active forment l'état fondamental de toute la structure. Le spectre de gain de la zone active se trouve dans une plage où la variation d'indice optique est importante lors de l'injection de porteurs.

Dans ce cas, lors de l'injection de porteurs, la diode émet sur plusieurs modes inclus dans la plage du spectre de gain et, en même temps, la longueur d'onde de ces modes se déplace en fonction de la densité de porteurs injectés.

Dans un troisième exemple, la cavité accordable est utilisée en tant que modulateur de Fabry-Pérot. Dans ce cas, l'espaceur (« spacer ») est constitué d'un SR-P et il n'y a pas de zone active. Lors de l'injection de porteurs, ceux-ci induisent une variation de la résonance de la cavité comme on l'a décrit plus haut.

Contrairement aux diodes émettrices de lumière, le modulateur est capable de fonctionner quelle que soit la durée de vie des porteurs dans le SR-P. Cette durée de vie est seulement fixée par le temps de réponse qu'on souhaite donner au modulateur. Il convient cependant de remarquer que le temps de réponse est directement lié à la densité d'excitation : plus le modulateur est sensible, plus il est lent, et réciproquement.

Que ce soit dans le cas d'une cavité émettrice de lumière ou d'un modulateur optique, l'injection de porteurs peut se faire aussi bien optiquement qu'électriquement. Dans le premier cas, on injecte des porteurs dans la structure au moyen d'un laser de pompe. Dans le deuxième cas, l'un des miroirs est dopé N et l'autre est dopé P et, pour injecter les porteurs, on polarise la diode ainsi formée en direct.

Dans un autre exemple, on couple deux cavités. La première émet de la lumière accordable et la deuxième, dont l'espaceur (« spacer ») est formé uniquement d'un SR-P sans zone active, résonne à une ou plusieurs longueurs d'onde accordables et module l'émission lumineuse de la première. On a deux courants de commande, un pour chaque cavité.

En variante, la première cavité est une cavité à résonance accordable et la deuxième est une cavité simple, sans SR-P ni zone active qui résonne à une ou plusieurs longueurs d'onde fixes. L'émission de lumière de la première cavité peut alors être commandée pour se trouver soit à la même longueur d'onde que la résonance de la deuxième cavité (état « passant »), soit à une autre longueur d'onde (état « non-passant »). Dans les deux cas décrits, on un système simple de modulation de lumière, susceptible de fonctionner au-delà de 1 GHz.

On donne maintenant des exemples plus spécifiques de l'invention.

Une caractéristique très intéressante de l'invention est qu'elle peut être mise en oeuvre avec n'importe quelle famille de semiconducteurs. On choisit cette famille en fonction de l'application visée, de la longueur d'onde désirée et de la technique de fabrication disponible.

Les semiconducteurs utilisés peuvent être des semiconducteurs III-V ou II-VI avec des structures cristallines de type zincblende ou wurtzite. Les hétérostructures de type zincblende doivent être réalisées sur des substrats ayant des indices cristallographiques $(n,l,m)$ élevés, avec $n \times l \times m \neq 0$, de manière à avoir des effets piézo-électriques. Pour une hétérostructure de type wurtzite, il suffit de former celle-ci suivant l'axe c du réseau cristallin de cette hétérostructure.

On peut par exemple utiliser :

(i) des hétérostructures InGaAs/InGaAsP sur des substrats en InP, pour des dispositifs fonctionnant aux longueurs d'onde utilisées dans les télécommunications (1,3 $\mu$m et 1,5 $\mu$m), et compatibles avec la technologie relative à InP

(ii) des hétérostructures GaInAsN/GaInAs sur des substrats en GaAs, comme alternative aux hétérostructures précédentes, pour des composants fonctionnant entre 1,3 $\mu$m et 1,5 $\mu$m

(iii) des hétérostructures InGaAs/GaAlAs sur des substrats en GaAs, pour des composants fonctionnant entre 0,8 $\mu$m et 1 $\mu$m

(iv) des hétérostructures du genre wurtzite InGaN/AlGaN sur des substrats en saphir, pour des composants fonctionnant entre 0,3 et 0,5 $\mu$m

(v) des hétérostructures CdHgTe/CdTe sur des substrats en CdZnTe, pour des composants fonctionnant à des longueurs d'onde supérieures à 1, 5 $\mu$m.

Dans l'invention, il est aussi possible d'exploiter les effets de polarisation spontanée, par exemple ceux qui se produisent dans les systèmes à base de InGaN/GaN sur saphir, de manière à créer des champs électriques dans les couches de la structure SR-P. Le sens et l'amplitude des champs électriques peuvent être contrôlés par exemple en changeant les compositions des alliages à partir desquels les couches sont formées (voir le document [6]).

On considère maintenant un exemple d'hétérostructure sur un substrat en InP fonctionnant à la longueur d'onde de 1,55 $\mu$m.

Il s'agit d'un exemple permettant d'obtenir un VCSEL accordable en longueur d'onde. La cavité résonante de ce dernier est épitaxiée de manière cohérente sur un substrat fait de InP (111). Les miroirs du VCSEL sont des réflecteurs de Bragg répartis, par exemple en GaAs/GaAlAs, et sont déposés de part et d'autre de la cavité par fusion de substrat (« wafer fusion »). A ce sujet, on se reportera au document [14].

Le SR-P du VCSEL est constitué de deux couches ayant la même bande interdite et des paramètres de maille tels que les champs piézo-électriques respectifs de ces couches aient la même intensité mais des sens opposés. Si l'on suppose que le coefficient piézo-électrique est constant pour les alliages constitutifs des couches du SR-P, de tels champs peuvent être obtenus grâce à des contraintes de même valeur absolue mais de signes opposés.

En supposant que l'état de contrainte est défini par rapport au paramètre de maille du substrat en InP, on donne dans le tableau qui suit un exemple pour lequel cette condition est satisfaite.

| Couche | Largeur de bande interdite (meV) | Paramètre de maille (nm) | Contrainte (%) |
|---|---|---|---|
| $(Ga_{0,17}In_{0,83})(AS_{0,55}P_{0,45})$ | 841 | 0,5906 | -0,63 |

(suite)

| Couche | Largeur de bande interdite (meV) | Paramètre de maille (nm) | Contrainte (%) |
|---|---|---|---|
| $(Ga_{0,56}In_{0,44})$ As | 841 | 0,5832 | +0,63 |

Pour cet exemple, en ce qui concerne les bandes interdites (à 300K) et les paramètres de maille des matériaux binaires, on s'est reporté au document [15]. On a utilisé une interpolation linéaire entre les paramètres des matériaux binaires et on a tenu compte de « l'inclinaison » (« bowing »): $b_{GaAsP}$=0, 5eV (voir le document [16]), $b_{GaInAs}$=0, 475eV (voir le document [17]), $b_{GaInP}$=0,5eV (voir le document [18], $b_{InAsP}$=0,1eV (voir le document [19]). Le paramètre de maille du substrat en InP vaut 0,58687 nm.

Dans ce cas, les contraintes sur une période du SR-P sont parfaitement compensées. Ceci est intéressant pour la réalisation de cavités résonantes assez épaisses. L'épaisseur critique pour chacune des couches est supérieure à 70 nm (voir le document [20]) et le champ piézo-électrique pour de telles contraintes est de l'ordre d'une centaine de kilo-volts par centimètre. L'épaisseur de chaque couche peut-être de 10 nm pour une centaine de périodes.

La zone active peut être constituée de puits quantiques sans contrainte en $Ga_{0,47}In_{0,53}As$ de 6 nm d'épaisseur, avec une largeur de bande interdite conduisant à une émission lumineuse ayant une longueur d'onde voisine de 1,55 $\mu$m.

Le SR-P et la zone active peuvent être inclus dans une microcavité pour réaliser le VCSEL mais pourraient aussi être inclus dans une diode laser à émission par la tranche.

On considère maintenant un exemple d'une hétérostructure faite à partir de matériaux II-VI.

On a fabriqué un SR-P avec de tels matériaux II-VI et l'on a étudié la dynamique de la photoluminescente d'un tel SR-P, en vue de mettre en évidence le décalage de bande interdite en fonction de l'injection de porteurs de charge.

Le SR-P est épitaxié sur un substrat $Cd_{0,88}Zn_{0,12}Te$ (211) et comprend un motif composé d'une couche en $Cd_{0,91}Mg_{0,09}Te$ et d'une couche en $Cd_{0,88}Zn_{0,22}Te$, ayant chacune 10 nm d'épaisseur, ce motif étant répété une centaine de fois. Le champ induit par les contraintes est de l'ordre d'une centaine de kV/cm dans cet exemple.

Les documents cités dans la présente description sont les suivants :

[1] J.Talghader et J.S. Smith, Appl. Phys. Lett. 66,335 (1995)

[2] M. Larson et J.S. Harris Jr., Appl. Phys. Lett. 68, 891 (1996)

[3] N.K. Dutta, W.S. Hobson, J. Lopata et G. Zydzik, Appl. Phys. Lett. 70, 1219 (1997)

[4] F. Faure, D. Le Guen, J.C. Simon et B. Landousies, Electron. Lett. 22, 795 (1986)

[5] S. Murata et I. Mito, Optical and Quantum Electronics 22, (1990), pages 1 à 15

[6] F. Bernardini, V. Fiorentini, D. Vanderbilt, Phys. Rev. B56 (1997), R1024

[7] D.A.B. Miller et al., Phys. Rev. B32, 1043 (1985)

[8] R. H. Yan, R.J. Simes et L.A. Coldren, IEEE J. Quantum Electron. 25, 2272 (1989)

[9] D.L. Smith et C. Mailhiot, Rev. Mod. Phys. 62, 173 (1990)

[10] E. Anastassakis, Phys. Rev. B 46, 4744 (1992)

[11] G.H. Dölher, Opt. and Quant. Electr. 22, S121 (1990)

[12] P. Michler, T. Lilienkamp, W. Ebeling, J. Gutoswtki, M. Behringer, M. Fehrer et D. Hommel, Appl. Phys. Lett. 72, 3320 (1998)

[13] Guido Mula, N.T. Pelekanos, P. Gentile, N. Magnea et J.L. Pautrat, Appl. Phys. Lett. 70, 856 (1997)

[14] D.I. Babic, K. Streubel, R.P. Mirin, N. M. Margarlit, J.E. Bowers, E.L. Hu, D.E. Mars, L. Yang et K. Carey, IEEE Photonics Technol. Lett. 7, 1225 (1995)

[15] Jacques I. Pankove, Optical Processes in Semiconductors, Dover Publications Inc., New York 1971

[16] J. Appl. Phys. 84, 3696 (1998)

[17] J. Appl. Phys. 69, 827 (1991)

[18] Phys. Rev. B 6, 1301 (1972)

[19] J. Appl. Phys. 80 846 (1996)

[20] K.W. Gossen, E.A. Caridi, T.Y. Chang, J. B. Stark, D.A.B. Miller et R.A. Morgan, Appl. Phys. Lett. 56, 715 (1990).

**Revendications**

1. Dispositif optique à semiconducteur, à cavité résonante accordable en longueur d'onde, ce dispositif comprenant une cavité résonante (2) et deux miroirs (4-6, 32-34) qui délimitent cette cavité, ce dispositif étant **caractérisé en ce qu'**il comprend en outre :

   ■ au moins un super-réseau (14, 38), qui est placé dans la cavité et formé à partir de couches semiconductrices piézoélectriques, et
■ des premiers moyens (20, 44) d'injection de porteurs de charge dans le super-réseau,

de manière à pouvoir modifier les propriétés optiques de ce super-réseau lorsque les porteurs de charge sont injectés dans ce dernier et obtenir ainsi un décalage en longueur d'onde des modes de résonance de la cavité.

2. Dispositif selon la revendication 1, comprenant en outre une zone active (10, 26) placée dans la cavité et destinée à émettre un rayonnement lors de l'injection de porteurs de charge dans cette zone active.

3. Dispositif selon la revendication 2, dans lequel les premiers moyens d'injection de porteurs de charge sont en outre prévus pour injecter ces porteurs de charge dans la zone active (10, 26) pour que cette zone active émette le rayonnement.

4. Dispositif selon la revendication 2, comprenant en outre des deuxièmes moyens d'injection de porteurs de charge prévus pour injecter ces porteurs de charge dans la zone active (10, 26) pour que cette zone active émette le rayonnement.

5. Dispositif selon l'une quelconque des revendications 2 à 4, ce dispositif étant apte à émettre un rayonnement laser, les miroirs (4, 6) étant perpendiculaires à l'axe de croissance des couches semiconductrices que comporte le dispositif, de manière à obtenir une émission verticale du rayonnement laser.

6. Dispositif selon l'une quelconque des revendications 2 à 4, ce dispositif étant apte à émettre un rayonnement incohérent, les miroirs (4, 6) étant perpendiculaires à l'axe de croissance des couches semiconductrices que comporte le dispositif, de manière à obtenir une émission verticale du rayonnement incohérent.

7. Dispositif selon l'une quelconque des revendications 2 à 4, ce dispositif étant apte à émettre un rayonnement laser, les miroirs (32, 34) étant parallèles à l'axe de croissance des couches semiconductrices que comporte le dispositif, de manière à obtenir une émission par la tranche du rayonnement laser.

8. Dispositif selon l'une quelconque des revendications 2 à 4, ce dispositif étant apte à émettre un rayonnement incohérent, les miroirs (32, 34) étant parallèles à l'axe de croissance des couches semiconductrices que comporte le dispositif, de manière à obtenir une émission par la tranche du rayonnement incohérent.

9. Dispositif selon l'une quelconque des revendications 1 à 8, dans lequel les premiers moyens (20, 44) d'injection de porteurs de charge sont de type électrique.

10. Dispositif selon l'une quelconque des revendications 1 à 8, dans lequel les premiers moyens d'injection de porteurs de charge sont de type optique.

11. Dispositif selon l'une quelconque des revendications 1 à 10, dans lequel les couches semiconductrices piézoélectriques ont des structures cristallines de type zincblende.

12. Dispositif selon l'une quelconque des revendications 1 à 10, dans lequel les couches semiconductrices piézoélectriques ont des structures cristallines de type wurtzite.

13. Dispositif de modulation d'intensité lumineuse comprenant le dispositif selon la revendication 2 optiquement couplé à une autre cavité résonante sans zone active mais dans laquelle est placé un super-réseau formé à partir de couches semiconductrices piézoélectriques, cette autre cavité étant apte à résonner à une ou une pluralité de longueurs d'onde accordables.

14. Dispositif de modulation d'intensité lumineuse comprenant le dispositif selon la revendication 2 optiquement couplé à une autre cavité résonante sans zone active ni super-réseau formé à partir de couches semiconductrices piézoélectriques, cette autre cavité étant apte à résonner à une ou une pluralité de longueurs d'onde fixes.

**Claims**

1. Optical semiconductor device having a wavelength-tunable resonant cavity, said device comprising a resonant cavity (2) and two mirrors (4-6, 32-34) which delimit this cavity, **characterised in that** it also comprises:

- at least one superlattice (14, 38) placed in the cavity and formed from piezoelectric semiconductor layers, and
- first means (20, 44) for injecting charge carriers into the superlattice,

so that the optical properties of the superlattice can be modified when the charge carriers are injected into said superlattice, thus creating an offset in the wavelength of the cavity resonance modes.

2. Device according to claim 1, further comprising an active region (10, 26) placed in the cavity and designed to emit radiation when the charge carriers are injected into the active region.

3. Device according to claim 2, wherein the first charge carrier injection means are also designed to inject the charge carriers into the active region (10, 26) so that the active region emits the radiation.

4. Device according to claim 2, further comprising second charge carrier injection means for injecting the charge carriers into the active region (10, 26) so that the active region emits the radiation.

5. Device according to any one of claims 2 to 4, said device being capable of emitting laser radiation, the mirrors (4, 6) being perpendicular to the growth axis of the semiconductor layers which the device comprises such that vertical emission of the laser radiation is obtained.

6. Device according to any one of claims 2 to 4, said device being capable of emitting incoherent radiation, the mirrors (4, 6) being perpendicular to the growth axis of the semiconductor layers which the device comprises such that vertical emission of the incoherent radiation is obtained.

7. Device according to any one of claims 2 to 4, said device being capable of emitting laser radiation, the mirrors (32, 34) being parallel to the growth axis of the semiconductor layers which the device comprises such that edge emission of the laser radiation is obtained.

8. Device according to any one of claims 2 to 4, said device being capable of emitting incoherent radiation, the mirrors (32, 34) being parallel to the growth axis of the semiconductor layers which the device comprises such that edge emission of the incoherent radiation is obtained.

9. Device according to any one of claims 1 to 8, wherein the first means (20, 44) for injecting charge carriers are electrical.

10. Device according to any one of claims 1 to 8, wherein the first means for injecting charge carriers are optical.

11. Device according to any one of claims 1 to 10, wherein the piezoelectric semiconductor layers have zincblende-type crystal structures.

12. Device according to any one of claims 1 to 10, wherein the piezoelectric semiconductor layers have wurtzite-type crystal structures.

13. Light intensity modulation device comprising the device according to claim 2 optically coupled to another resonant cavity with no active region but within which there is placed a supperlattice formed from piezoelectric semiconductor layers, said other cavity being capable of resonating at one or more tunable wavelengths.

14. Light intensity modulation device comprising the device according to claim 2 optically coupled to an other resonant cavity with no active region or superlattice formed from piezoelectric semiconductor layers, said other cavity being capable of resonating at one or more fixed wavelengths.

**Patentansprüche**

1. Optische Halbleitervorrichtung mit Wellenlängenabstimmbarem Resonanzhohlraum, wobei die Vorrichtung einen Resonanzhohlraum (2) und zwei Spiegel (4-6, 32-34) aufweist, die diesen Hohlraum begrenzen, wobei die Vorrichtung **dadurch gekennzeichnet ist, dass** sie ferner aufweist:

■ mindestens ein Übergitter (14, 38), das in dem Hohlraum angeordnet ist und aus piezoelektrischen Halbleiterschichten gebildet ist, und

■ erste Mittel (20, 44) zum Injizieren von Ladungsträgern in das Übergitter,

um die optischen Eigenschaften des Übergitters verändern zu können, wenn die Ladungsträger in letzteres injiziert werden, und um auf diese Weise eine Wellenlängen-Verschiebung der Resonanzmodi des Hohlraums zu erzielen.

2. Vorrichtung gemäß Anspruch 1, ferner eine aktive Zone (10, 26) aufweisend, die in dem Hohlraum angeordnet ist und vorgesehen ist zum Emittieren einer Strahlung beim Injizieren von Ladungsträgern in die aktive Zone.

3. Vorrichtung gemäß Anspruch 2, wobei die ersten Mittel zum Injizieren von Ladungsträgern ferner vorgesehen sind zum Injizieren der Ladungsträger in die aktive Zone (10, 26), zum Emittieren der Strahlung durch die aktive Zone.

4. Vorrichtung gemäß Anspruch 2, ferner zweite Mittel zum Injizieren von Ladungsträgern aufweisend, die vorgesehen sind zum Injizieren der Ladungsträger in die aktive Zone (10, 26), zum Emittieren der Strahlung durch die aktive Zone.

5. Vorrichtung gemäß einem der Ansprüche 2 bis 4, wobei die Vorrichtung geeignet ist zum Emittieren von Laserstrahlung, wobei die Spiegel (4, 6) senkrecht zu der Wachstumsachse der Halbleiterschichten sind, die die Vorrichtung aufweist, zum Erhalten einer vertikalen Emission der Laserstrahlung.

6. Vorrichtung gemäß einem der Ansprüche 2 bis 4, wobei die Vorrichtung geeignet ist zum Emittieren einer inkohärenten Strahlung, wobei die Spiegel (4, 6) senkrecht zu der Wachstumsachse der Halbleiterschichten sind, die die Vorrichtung aufweist, zum Erhalten einer vertikalen Emission der inkohärenten Strahlung.

7. Vorrichtung gemäß einem der Ansprüche 2 bis 4, wobei die Vorrichtung geeignet ist zum Emittieren einer Laserstrahlung, wobei die Spiegel (32, 34) parallel zu der Wachstumsachse der Halbleiterschichten sind, die die Vorrichtung aufweist, zum Erhalten einer Kantenemission der Laserstrahlung.

8. Vorrichtung gemäß einem der Ansprüche 2 bis 4, wobei die Vorrichtung geeignet ist zum Emittieren einer inkohärenten Strahlung, wobei die Spiegel (32, 34) parallel zu der Wachstumsachse der Halbleiterschichten sind, die die Vorrichtung aufweist, zum Erhalten einer Kantenemission der inkohärenten Strahlung.

9. Vorrichtung gemäß einem der Ansprüche 1 bis 8, wobei die ersten Mittel (20, 44) zum Injizieren von Ladungsträgern elektrischer Art sind.

10. Vorrichtung gemäß einem der Ansprüche 1 bis 8, wobei die ersten Mittel zum Injizieren von Ladungsträgern optischer Art sind.

11. Vorrichtung gemäß einem der Ansprüche 1 bis 10, wobei die piezoelektrischen Halbleiterschichten kristalline Strukturen des Typs Zinkblende aufweisen.

12. Vorrichtung gemäß einem der Ansprüche 1 bis 10, wobei die piezoelektrischen Halbleiterschichten kristalline Strukturen des Typs Wurtzit aufweisen.

13. Vorrichtung zur Lichtintensitätsmodulation, die die Vorrichtung gemäß Anspruch 2 aufweist, die optisch mit einem anderen Resonanzhohlraum gekoppelt ist, der keine aktive Zone aufweist, in welchem jedoch ein Übergitter angeordnet ist, das aus piezoelektrischen Halbleiterschichten gebildet ist, wobei dieser andere Holraum geeignet ist zum Mitschwingen mit einer oder einer Mehrzahl von abstimmbaren Wellenlängen.

14. Vorrichtung zur Lichtintensitätsmodulation, die die Vorrichtung gemäß Anspruch 2 aufweist, die optisch mit einem anderen Resonanzhohlraum gekoppelt ist, der weder eine aktive Zone noch ein Übergitter aufweist, das aus piezoelektrischen Halbleiterschichten gebildet ist, wobei dieser andere Hohlraum geeignet ist zum Mitschwingen mit einer oder einer Mehrzahl von festen Wellenlängen.

EP 1 067 643 B1

FIG. 1

FIG. 2

14

FIG. 3

FIG. 4

FIG. 5

FIG. 6

FIG. 7

FIG. 8

FIG. 9

FIG. 10

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **J.TALGHADER ; J.S. SMITH.** *Appl. Phys. Lett.,* 1995, vol. 66, 335
- **M. LARSON ; J.S. HARRIS JR.** *Appl. Phys. Lett.,* 1996, vol. 68, 891
- **N.K. DUTTA ; W.S. HOBSON ; J. LOPATA ; G. ZY-DZIK.** *Appl. Phys. Lett.,* 1997, vol. 70, 1219
- **F. FAURE ; D. LE GUEN ; J.C. SIMON ; B. LAN-DOUSIES.** *Electron. Lett.,* 1986, vol. 22, 795
- **S. MURATA ; I. MITO.** *Optical and Quantum Electronics,* 1990, vol. 22, 1-15
- **F. BERNARDINI ; V. FIORENTINI ; D. VANDER-BILT.** *Phys. Rev. B,* 1997, vol. 56, R1024
- **D.A.B. MILLER et al.** *Phys. Rev. B,* 1985, vol. 32, 1043
- **R. H. YAN ; R.J. SIMES ; L.A. COLDREN.** *IEEE J. Quantum Electron.,* 1989, vol. 25, 2272
- **D.L. SMITH ; C. MAILHIOT.** *Rev. Mod. Phys.,* 1990, vol. 62, 173
- **E. ANASTASSAKIS.** *Phys. Rev. B,* 1992, vol. 46, 4744
- **G.H. DÖLHER.** *Opt. and Quant. Electr.,* 1990, vol. 22, S121
- **P. MICHLER ; T. LILIENKAMP ; W. EBELING ; J. GUTOSWTKI ; M. BEHRINGER ; M. FEHRER ; D. HOMMEL.** *Appl. Phys. Lett.,* 1998, vol. 72, 3320
- **GUIDO MULA ; N.T. PELEKANOS ; P. GENTILE ; N. MAGNEA ; J.L. PAUTRAT.** *Appl. Phys. Lett.,* 1997, vol. 70, 856
- **D.I. BABIC ; K. STREUBEL ; R.P. MIRIN ; N. M. MARGARLIT ; J.E. BOWERS ; E.L. HU ; D.E. MARS ; L. YANG ; K. CAREY.** *IEEE Photonics Technol. Lett.,* 1995, vol. 7, 1225
- **JACQUES I. PANKOVE.** Optical Processes in Semiconductors. Dover Publications Inc, 1971
- *J. Appl. Phys.,* 1998, vol. 84, 3696
- *J. Appl. Phys.,* 1991, vol. 69, 827
- *Phys. Rev. B,* 1972, vol. 6, 1301
- *J. Appl. Phys.,* 1996, vol. 80, 846
- **K.W. GOSSEN ; E.A. CARIDI ; T.Y. CHANG ; J. B. STARK ; D.A.B. MILLER ; R.A. MORGAN.** *Appl. Phys. Lett.,* 1990, vol. 56, 715